# EUROPEAN PATENT APPLICATION

(11) **EP 1 515 149 A2**
(43) Date of publication of application: **16.03.2005**
(21) Application number: 04021139.3
(22) Date of filing: 06.09.2004
(51) Int. Cl.: G01R 33/025, H05K 9/00

(54) **Magnetic shielding system**

(30) Priority: 11.09.2003 JP 2003320422
(71) Applicant: KYUSHU UNIVERSITY, Fukuoka City Fukuoka Pref. (JP)
(72) Inventor: Tashiro, Kunihisa, Kasuga City Fukuoka Pref. (JP); Sasada, Ichiro, Fukuoka City Fukuoka Pref. (JP)
(74) Representative: von Hellfeld, Axel, Dr. Dipl.-Phys.

(57) **Abstract**

A magnetic shielding system includes a magnetic ribbon arranged at the cylindrical shape. The easy axis of magnetization of said magnetic ribbon corresponds to the longitudinal direction of the magnetic ribbon and the axial direction of the said cylindrical shape is parallel or substantially parallel to the longitudinal direction.
The magnetic shielding system comprises a coil for generating the magnetic shaking field in the magnetic ribbon, the winding direction of the coil is orthogonal or substantially orthogonal to the longitudinal direction. The magnetic path of the magnetic shaking field is closed by arranging the magnetic ribbons so as to close the coil.

## Description

### BACKGROUND OF THE INVENTION

### 1. Field of the Invention

The present invention relates to a magnetic shielding system comprising a magnetic ribbon arranged in the cylindrical shape with open ends, the magnetic shielding system having a shielding function against a magnetic field at the axial direction of the ribbon.

### 2. Prior Art

Conventionally, the magnetic shielding system is utilized in a field requiring a magnetically shielding space (screen a magnetic field in the DC and low frequency region). In such a magnetic shielding system, for example, a plurality of cylinders with open ends are arranged concentrically with one another. In order to obtain a large shielding effect on the magnetic field at the radial direction of each of the cylinders, a ribbon composed of a rectangular magnetic body forms the outer face of at least one cylinder ordered from the innermost so that the longitudinal direction of the ribbon is parallel or substantially parallel to the circular direction of the cylinder and a coil for flowing the magnetic shaking current is wound on the cylinder. Also, in order to obtain a large shielding effect on the magnetic field at the axial direction of each of the cylinders, a ribbon composed of a rectangular magnetic body forms the outer face of at least one cylinder ordered from the outermost so that the longitudinal direction of the ribbon is parallel or substantially parallel to the axial direction of the cylinder and a coil for flowing the magnetic shaking current is wound on the cylinder (see Fig. 4 of U. S. Patent No. 6,229,423 B1 filed on May 8, 2001, for example).

However, in such a magnetic shielding system, it is necessary to generate a large shaking current required for obtaining an optimum shielding effect against a magnetic field at a axial direction of each of the cylinders. Concretely, it is necessary to generate the shaking current about ten times of the current required for obtaining an optimum shielding effect against a magnetic field in a radial direction of each of the cylinders.

### SUMMARY OF THE INVENTION

It is an object of the present invention to provide a magnetic shielding system achieving a sufficient shield effect against the magnetic field at a axial direction of the system with a relative small shaking current.

The present invention provides a magnetic shielding system with a magnetic ribbon arranged at the cylindrical shape, the easy axis of magnetization of the magnetic ribbon corresponding to the longitudinal direction of the magnetic ribbon and the axial direction of the cylindrical shape being parallel or substantially parallel to the longitudinal direction, the system comprising a coil for generating the magnetic shaking field in the magnetic ribbon, the winding direction of the coil being perpendicular or substantially perpendicular to the longitudinal direction,
the magnetic flux path of the magnetic shaking field being closed by arranging the magnetic ribbons so as to close the coil.

According to the present invention, as the winding direction of the coil is perpendicular or substantially perpendicular to the longitudinal direction of magnetic ribbons, the magnetic shaking field is applied along the easy axis of magnetization and the magnetic path of the magnetic shaking field is closed by arranging the magnetic ribbons so as to close the coil. Thereby, it is possible to generate the shaking current required for obtaining an optimum shielding effect against a magnetic field in the axial direction of the cylindrical shape substantially same as a current required for obtaining an optimum shielding effect against the magnetic field in a radial direction of the cylindrical direction. Therefore, it is possible to achieve an optimum shielding function against the magnetic field in the axial direction with a relative small shaking current.

Preferably, the system further comprises a winding core composed of a deformable non-magnetic material or an inner core composed of a non-magnetic material. In order to obtain a sufficient shield function with light weight, it is preferable to compose the magnetic ribbon of a material with a small coercitity and a rectangular hysteresis characteristic such as Metglas 2705M.

### BRIEF DESCRIPTION OF THE DRAWINGS

Fig. 1A is a front view of a shield panel used for forming a magnetic shielding system according to the present invention, Fig. 1B is a side view thereof and Fig. 1C is a top view thereof.
Fig. 2 is a figure for explaining another method of manufacturing a magnetic shielding system according to the present invention.
Fig. 3 is a figure for explaining the principle of operation of a conventional magnetic shielding system.
Fig. 4 is a figure for explaining the principle of operation of a magnetic shielding system according to the present invention.
Fig. 5 is a figure showing the shield ratios in a axial direction of a conventional magnetic shielding system and a magnetic shielding system according to the present invention.
Fig. 6 is a schematic figure of a magnetic shielding system according to the present invention formed by combining three curved shield panels.

### DETAILED DESCRIPTION OF PREFERRED EMBODIMENTS

Embodiments of a magnetic shielding system according to the present invention are described in detail with reference to the drawings.

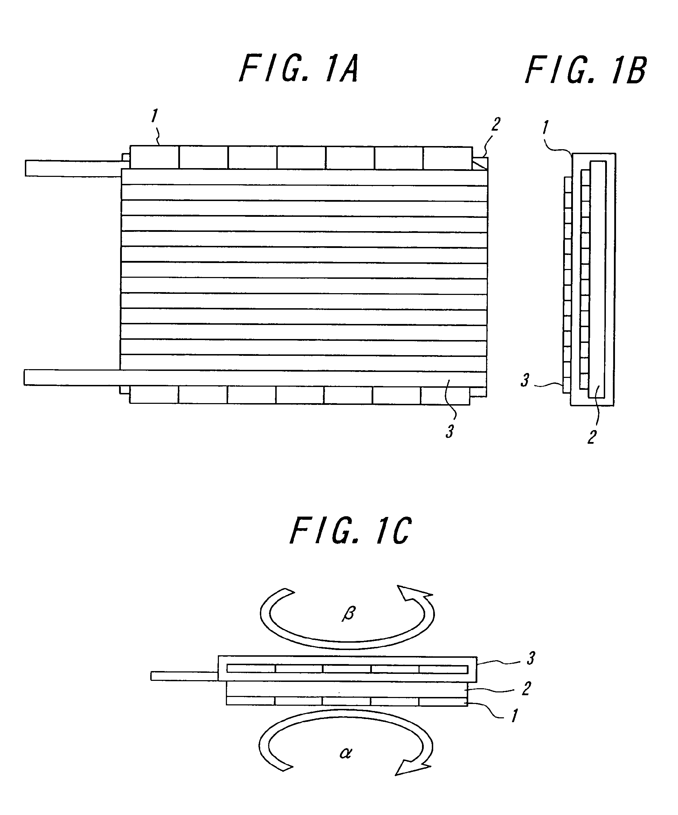

Fig. 1A is a front view of a shield panel used for forming a magnetic shielding system according to the present invention, Fig. 1B is a side view thereof, and Fig. 1C is a top view thereof. This shield panel comprises magnetic ribbons 1, a deformable non-magnetic material (sponge) 2 and a coil 3. As shown in Fig. 1C, a winding core composed of the magnetic ribbons 1 and the sponge 2 is formed into a cylinder with open ends by rolling this shield panel in the direction of arrow α or β. A axial direction of the cylinder is parallel or substantially parallel to a longitudinal direction of each of the magnetic ribbons 1. As a result, a magnetic shielding system according to the present invention is formed.

In this embodiment, the magnetic ribbons 1 are composed of Metglas 2705M (brand name by Allied, Inc. in USA) for example, and the winding core formed of the sponge 2 is composed of a deformable non-magnetic material such as a paper, a resin or the like. A winding direction of the coil 3 is perpendicular or substantially perpendicular to the longitudinal direction of each of the magnetic ribbons 1. Further, each of the magnetic ribbons 1 has an easy axis of magnetization in the longitudinal direction thereof, and is formed so that the magnetic flux path of a magnetic shaking field is closed by arranging the magnetic ribbons so as to close the coil 3, as described after in detail.

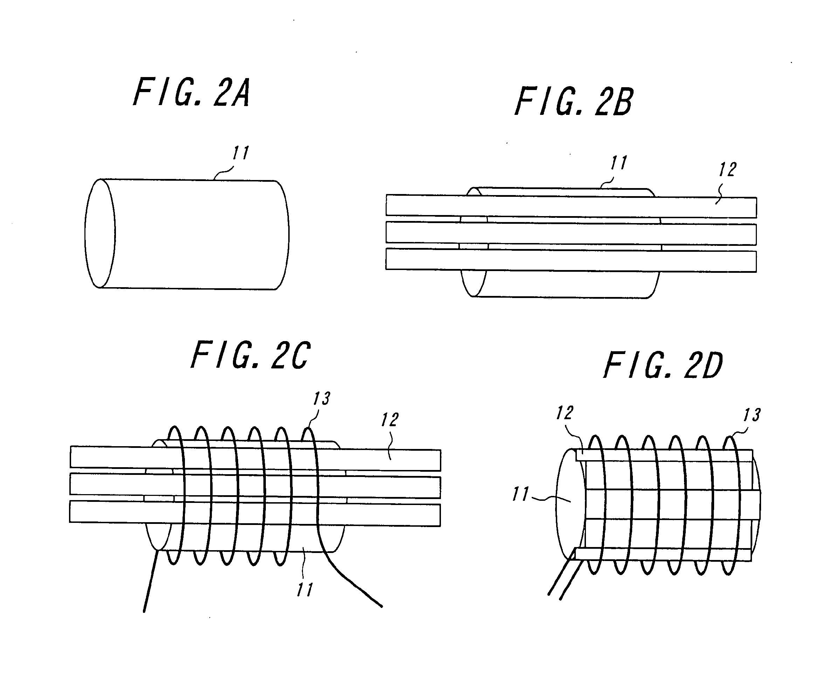

Figs. 2A to 2D are figures for explaining a method of manufacturing another magnetic shielding system according to the present invention. In this case, magnetic ribbons 12 (Fig. 2B) composed of a cobalt-based amorphous material are stuck on the side face of a cylindrical pipe 11 (Fig. 2A) composed of a non-magnetic material such as paper, resin, FRP (fiber reinforced plastics), non-magnetic metal, carbon fiber or the like.

Next, a coil 13 is wound around the pipe 11 and the magnetic ribbons 12 at perpendicular or substantially perpendicular to the easy axis of magnetization of magnetic ribbons 12 (Fig. 2C) and the magnetic path is closed by folding the magnetic ribbons 12, and the coil 13 is wound at the opposite direction to the winding direction shown in Fig. 2C (Fig. 2D). In this case, also, the magnetic ribbons 12 are formed into a cylinder with open ends and a axial direction of the cylinder is parallel or substantially parallel to a longitudinal direction of the magnetic ribbons 12. As described after in detail, the magnetic flux path of a magnetic shaking field is closed by arranging the magnetic ribbons so as to close the coil 13.

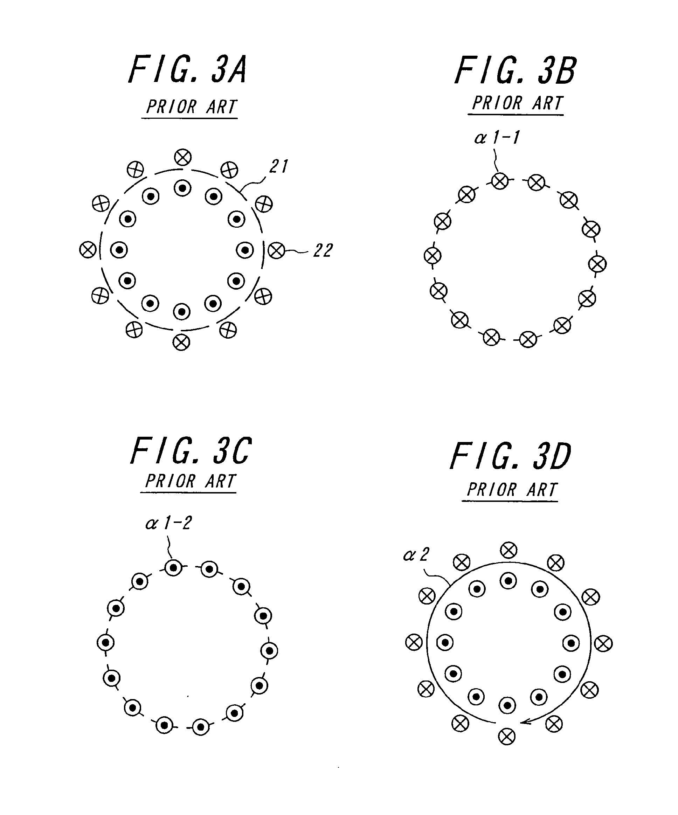

Here, the principle of operation of a magnetic shielding system according to the present invention is described in comparison with that of a conventional magnetic shielding system described in U. S. Patent No. 6,229,423 B1 filed on May 8, 2001. In case of a conventional magnetic shielding system, as shown in Fig. 3A, in order to achieve a sufficient shield function against an external magnetic field in a axial direction of a cylinder, a longitudinal direction of each of magnetic ribbons 21 is parallel or substantially parallel to the axial direction of the cylinder and a winding direction of a coil for generating a magnetic shaking field is also parallel or substantially parallel to the axial direction of the cylinder. As a result, as shown in Fig. 3B or 3C, an open magnetic path α1-1 or α1-2 formed by an easy axis of magnetization of a magnetic ribbon is formed. And as shown in Fig. 3D, a magnetic shaking field α2 generated by the coil is formed and this magnetic shaking field α2 is perpendicular to the magnetic path α1-1 or α1-2. Therefore, as it is impossible to close the magnetic shaking field α2 generated by the coil due to the open magnetic paths α1-1 or α1-2 formed by the easy axis of magnetization of the magnetic ribbon, the efficiency of magnetic shaking decreases.

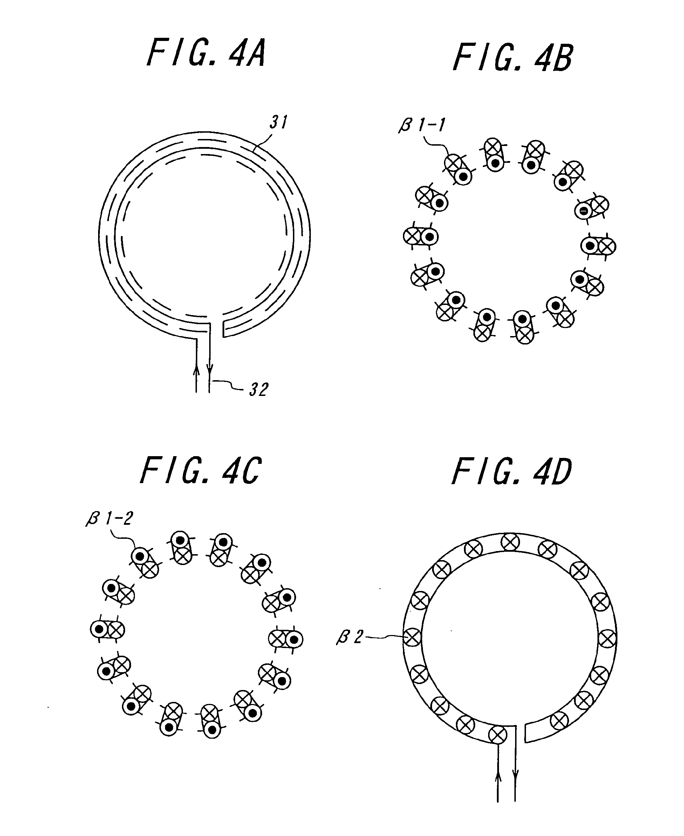

On the other hand, in case of a magnetic shielding system according to the present invention, as shown in Fig. 4A, magnetic ribbons 31 are arranged so as to close a coil 32. As a result, as shown in Fig. 4B or 4C, closed magnetic path β1-1 or β1-2 formed by an easy axis of magnetization of each of the magnetic ribbons is formed, and as shown in Fig. 4D, magnetic flux path B2 of a magnetic shaking field generated by the coil is formed in parallel to the magnetic path β1-1 or β1-2. Therefore, as the magnetic shaking field β2 formed by the coil are closed by the closed magnetic path β1-1 or β1-2 generated by the easy axis of magnetization, the efficiency of shaking magnetic increases.

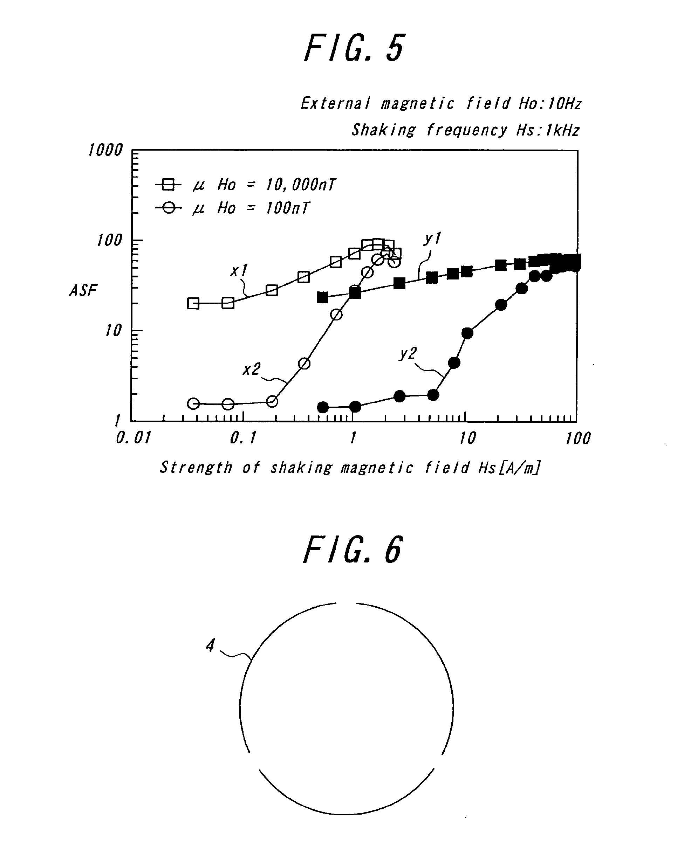

Fig. 5 is a figure showing the shield ratios in a axial direction of a conventional magnetic shielding system and a magnetic shielding system according to the present invention. Fig. 5 shows the shield ratio ASF (external magnetic field Ho/internal magnetic field Hi) in a axial direction of the magnetic shielding system according to the present invention as shown in Fig. 4D (curves x1, x2) where the shape ratio L/D of a length L in the axial direction of the cylinder formed by the magnetic ribbons to an inner diameter D of the cylinder is 400/160 = 2.5, and the shield ratio ASF in the axial direction of the cylinder as shown in Fig. 3A (curves y1, y2).

In case of a cylindrical magnetic shielding system with open ends having an aspect ratio of 2.5 in L/D, the theoretical maximum shield ratio ASF is about 100 however large the magnetic permeability and thickness of a magnetic body to be used are made. In a magnetic shielding system according to the present invention, as the axial direction of the magnetic ribbon and the direction of a magnetic shaking field to be applied are parallel to each other and the magnetic flux path of the magnetic shaking field is closed, the maximum value of the shield ratio ASF is realized by a magnetic shaking field of about 2.4 A/m.

As there is no non-linearity in magnetic permeability even if an external magnetic field is in the order of 10,000 nT similar to the conventional magnetic shielding system because of an effect of magnetic shaking, harmonic components of an external magnetic field do not exist in the shield space. And a high ASF is kept because of a high incremental permeability even in a weak magnetic field as in the order of 100 nT.

According to the present invention, it is possible to generate a shaking current required for obtain an optimum shielding effect against a magnetic field in the axial direction of the cylinder about 1/10 smaller than that of a conventional magnetic shielding system as shown in Fig. 3A and thus make it substantially same as a current required for obtaining a shield effect against a magnetic field in a radial direction of the cylinder. As a result, it is possible to achieve a sufficient shield function against a magnetic field in the axial direction of the cylinder with a relatively small shaking current.

In the conventional magnetic shielding system as shown in Fig. 3A, also, an audible noise of magneto striction (noise from a magnetic material) occurs in a magnetic shielding system in case of optimizing the magnitude of a magnetic shaking field. On the other hand, there is no audible noise of magneto striction in a magnetic shielding system according to the present invention.

The present invention is not limited to the above-described embodiments but can be modified and deformed in various manners.

For example, in the above-mentioned embodiment, the magnetic shielding system according to the present invention is formed with the winding core or the inner core composed of a non-magnetic material, however, it is also possible to make the magnetic shielding system according to the present invention without the winding core or the inner core. Also, the magnetic material for forming the magnetic ribbon can be composed of an amorphous alloy, a nano-crystalline alloy or the like other than Metglas 2705M (trade name by Allied, Inc. in USA).

Further, in Fig. 1, the magnetic shielding system is formed with a single shield panel, however, it is also possible to make the magnetic shielding system according to the present invention by combining a plurality of curved shield panels in direction α or β. As an example, Fig. 6 shows a magnetic shielding system according to the present invention formed by combining three curved magnetic shield panels 4.

The magnetic shielding system according to the present invention is utilized in a field requiring a magnetically shielded space and the following are examples thereof:
- Biomangetism measurement: MEG (Magnetoencephalography), MCG (Magnetocardiography)
- Electron beam applying apparatus: EB apparatus (Electron beam exposure apparatus), Electron microscope
- Physics: Lithogenous magnetism, Magnetic biosensor, Photomultiplier

## Claims

1. A magnetic shielding system with a magnetic ribbon arranged at the cylindrical shape, the easy axis of magnetization of said magnetic ribbon corresponding to the longitudinal direction of said magnetic ribbon and the axial direction of said cylindrical shape being parallel or substantially parallel to said longitudinal direction, said system comprising a coil for generating the magnetic shaking field in said magnetic ribbon, the winding direction of said coil being perpendicular or substantially perpendicularly to said longitudinal direction,
the magnetic path of said magnetic shaking field being closed by arranging said magnetic ribbons so as to close said coil.

2. The system according to claim 1, wherein said magnetic ribbon is composed of a material with a small coercitity and a rectangular hysteresis characteristic.

3. The system according to claim 1, further comprising a winding core composed of a deformable non-magnetic material.

4. The system according to claim 3, wherein said magnetic ribbon is composed of a material with a small coercitity and a rectangular hysteresis characteristic.

5. The system according to claim 1, further comprising an inner core composed of a non-magnetic material.

6. The system according to claim 5, wherein said magnetic ribbon is composed of a material with a small coercitity and a rectangular hysteresis characteristic.
